# EUROPEAN PATENT APPLICATION

(11) **EP 2 402 980 A2**
(43) Date of publication of application: **04.01.2012**
(21) Application number: 11171571.0
(22) Date of filing: 27.06.2011
(51) Int. Cl.: H01J 37/34

(54) **Methods of arc detection and suppression during rf sputtering of a thin film on a substrate**

(30) Priority: 30.06.2010 US 827029
(71) Applicant: PrimeStar Solar, Inc, Arvada, CO 80004 (US)
(72) Inventor: Halloran, Sean Timothy, Arvada, CO Colorado 80004 (US)
(74) Representative: Bedford, Grant Richard

(57) **Abstract**

Methods and systems of arc suppression during RF sputtering of a thin film from a semiconducting target 104 onto a substrate 12 are provided. During sputtering, an alternating current of RF frequency can be applied to a semiconducting target 104 to form a plasma 110. Upon formation of an arc 112 extending from the target 104, an arc signature can be detected, where the arc signature is simultaneously defined by decreasing plasma voltage from an initial sputtering plasma voltage to an arc plasma voltage and increasing reflective power from an initial sputtering reflective power to an arc reflective power. Upon identification of the arc signature, the alternating current can be temporarily interrupted to the semiconducting target 104 to suppress the arc 112 extending from the target 104. Thereafter, the alternating current from the electrical power supply 102 can be reapplied to the semiconducting target 104.

## Description

The subject matter disclosed herein relates generally to methods of sputtering a thin film on a substrate. More particularly, the subject matter disclosed herein relates to methods of arc suppression during sputtering of a thin film layer on a substrate.

Sputtering deposition involves ejecting material from a target (i.e., the material source), and depositing the ejected material onto the substrate to form the film. A plasma discharge is sustained between the target and the substrate in the sputtering chamber during deposition by coupling RF or DC power from an electrical power source to the plasma, where the target acts as a cathode having a negative potential during sputtering.

Due to the charge build-up on the cathode, arcs can sometimes form between the target (i.e., the cathode) and other materials in the chamber having an anode potential (e.g., the chamber walls, the plasma field, the substrate, the substrate carrier, etc.). Once formed, the arc can continue to be supplied power (via the electrical power source) and can result in significant damage to the target. Such damage can result in non-uniform layers being formed, as well as delays in the manufacturing process.

Arc detection for DC plasmas is available and generally works well in minimizing the effects of any arc that forms in the chamber. Additionally, in certain low-frequency AC sputtering conditions, any arcs formed can self-extinguish through alternating the voltage potential of the cathode. For example, if an arc does form while the cathode has a negative potential, then the arc can extinguish as the cathode alternates to a positive potential, and vice versa. However, as the frequency of the AC sputtering conditions increases to high power, high frequency conditions (e.g., RF sputtering) and/or for sputtering of an oxide or other insulating target, arcs can and do form. These arcs can disrupt the sputtering process, lead to non-uniformity of thin films on a single substrate and between a plurality of substrates of a continuing manufacturing process, and destroy the target material increasing costs to the sputtering process. Without wishing to be bound by any particular theory, it is believed that the nature of the high frequency conditions prevents the arc from self-extinguishing as the potential of the cathode alternates due to the speed of the change (i.e., the short wavelengths of the high frequency wave leaving only an extremely short period for the arc to extinguish). Additionally, in large area deposition chambers operating at high frequencies, impedance matching networks can tune to the arc, providing power directly to the arc while still maintaining a plasma. These continuous deposition processes used for mass manufacturing cannot be relied upon power monitoring alone to detect and kill an arc formed in the chamber. Likewise, monitoring the DC bias may not indicate an arc as the plasma is maintained even after formation of the arc.

Thus, a need exists for methods of detecting the formation of an arc during RF sputtering and minimizing its effect on the deposition process, particularly in large-scale, mass manufacturing processes.

Various aspects and advantages of the invention will be set forth in part in the following description, or may be clear from the description, or may be learned through practice of the invention.

A method is generally disclosed in one embodiment of arc suppression during sputtering of a thin film from a semiconducting target onto a substrate. According to the method, an alternating current (e.g., at a frequency of about 500 kHz to 15 MHz) from an electrical power supply is applied to the semiconducting target to form a plasma between the substrate and the semiconducting target. Upon formation of an arc extending from the target, an arc signature can be detected, where the arc signature is simultaneously defined by decreasing plasma voltage from an initial sputtering plasma voltage to an arc plasma voltage and increasing reflective power from an initial sputtering reflective power to an arc reflective power. Upon identification of the arc signature, the alternating current from the electrical power supply can be temporarily interrupted to the semiconducting target to suppress the arc extending from the target. Thereafter, the alternating current from the electrical power supply can be reapplied to the semiconducting target. In one particular embodiment, the method can be utilized to form a cadmium sulfide thin film layer on a glass superstrate, such as during a method for manufacturing a cadmium telluride based thin film photovoltaic device.

A sputtering system is also generally disclosed for arc detection and suppression during sputtering of a thin film from a semiconducting target onto a substrate. The system can include a sputtering chamber configured to receive a substrate and a semiconductor target. An electrical power supply wired to the sputtering chamber can supply alternating current to the semiconducting target to form a plasma between the substrate and the semiconducting target. A switch between the electrical power and the sputtering chamber can be configured to supply the alternating current to the sputtering chamber when closed and interrupt the alternating current to the sputtering chamber when open. A pair of sensors can be positioned within the sputtering chamber to measure the plasma voltage and the reflective power during sputtering.

These and other features, aspects and advantages of the present invention will become better understood with reference to the following description and appended claims. The accompanying drawings, which are incorporated in and constitute a part of this specification, illustrate embodiments of the invention and, together with the description, serve to explain the principles of the invention.

In the drawings:
Fig. 1 shows a general schematic of a cross-sectional view of an exemplary sputtering chamber;
Fig. 2 shows a close-up view of a corner of the exemplary sputtering chamber of Fig. 1 where an arc has formed between the target and the shield;
Fig. 3 shows a view of the target from inside the sputtering chamber of Fig. 1;
Fig. 4 shows a cross-sectional view of another exemplary sputtering chamber;
Fig. 5 shows a general schematic of the system for detecting and suppressing arcs formed in the exemplary sputtering chamber of Fig. 1;
Fig. 6 shows the change in voltage potential upon the formation of an arc and subsequent suppression of the arc according to one example;
Fig. 7 shows an exemplary arc signature simultaneously defined by decreasing plasma voltage and increasing reflective power according to the formation of an arc in one example;
Fig. 8 shows a flow diagram of an exemplary method of suppressing arcs formed during sputtering from a target;
Fig. 9 shows a general schematic of a cross-sectional view of an exemplary cadmium telluride thin film photovoltaic device according to one embodiment of the present invention; and
Fig. 10 shows a flow diagram of an exemplary method of manufacturing a photovoltaic module including a cadmium telluride thin film photovoltaic device.

Repeat use of reference characters in the present specification and drawings is intended to represent the same or analogous features or elements.

Reference now will be made in detail to embodiments of the invention, one or more examples of which are illustrated in the drawings. Each example is provided by way of explanation of the invention, not limitation of the invention. In fact, it will be apparent to those skilled in the art that various modifications and variations can be made in the present invention without departing from the scope or spirit of the invention. For instance, features illustrated or described as part of one embodiment, can be used with another embodiment to yield a still further embodiment. Thus, it is intended that the present invention covers such modifications and variations as come within the scope of the appended claims and their equivalents.

In the present disclosure, when a layer is being described as "on" or "over" another layer or substrate, it is to be understood that the layers can either be directly contacting each other or have another layer or feature between the layers. Thus, this description is simply describing the relative position of the layers to each other and does not necessarily mean "on top of" since the relative position above or below depends upon the orientation of the device to the viewer. Additionally, the term "thin" describing the photovoltaic device and any film layers generally refers to the film layer having a thickness less than about 10 µm. It is to be understood that the ranges and limits mentioned herein include all ranges located within the prescribed limits (i.e., subranges). For instance, a range from about 100 to about 200 also includes ranges from 110 to 150, 170 to 190, 153 to 162, and 145.3 to 149.6. Further, a limit of up to about 7 also includes a limit of up to about 5, up to 3, and up to about 4.5, as well as ranges within the limit, such as from about 1 to about 5, and from about 3.2 to about 6.5.

Generally speaking, methods are presently disclosed of arc detection and suppression during RF sputtering of a thin film on a substrate. The suppression of arcs formed during the sputtering process can allow for better uniformity of the thin film layer being formed throughout the sputtering process. That is, not only can the thin film layer have better uniformity on the individual substrates, but the thin film layers on each substrate can also be substantially uniform from substrate to substrate. Thus, the presently disclosed methods are particularly useful during mass production of thin film substrates in a commercial setting, such as during the formation of cadmium sulfide layers during the mass production of cadmium telluride based thin film photovoltaic devices. Although the present disclosure is discussed in reference to sputtering cadmium sulfide layers during the manufacture of cadmium telluride based thin film photovoltaic devices, the following discussion is not intended to limit the broader aspects of the present disclosure.

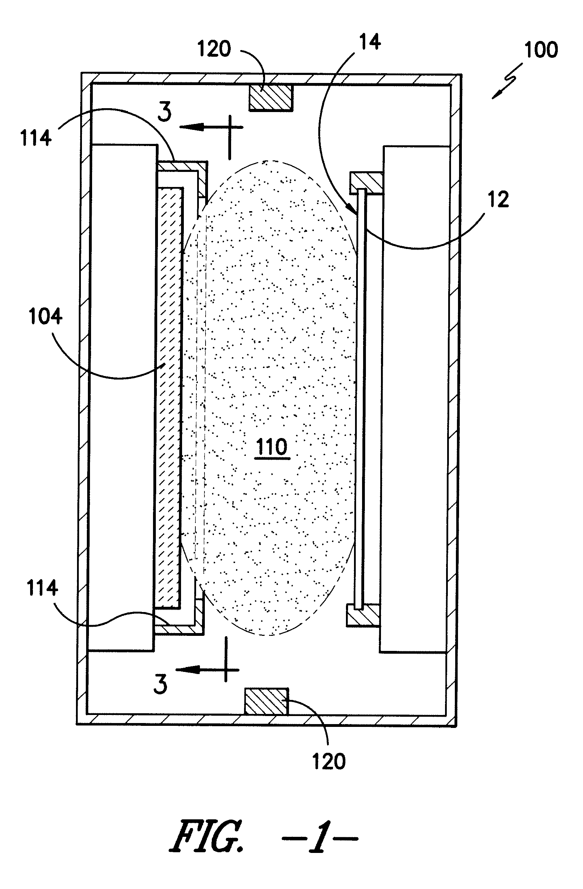

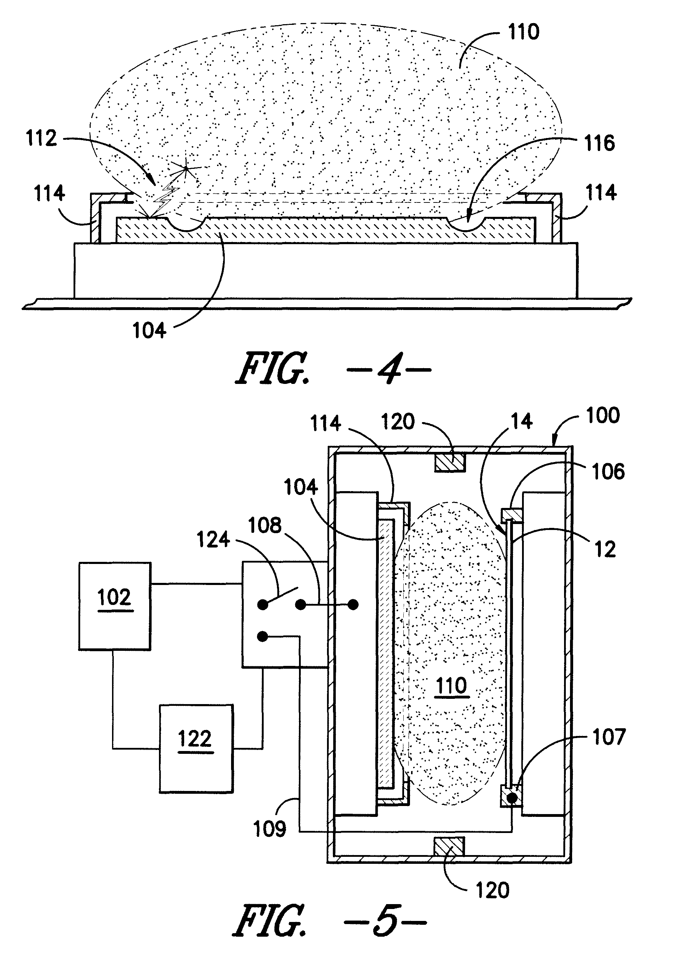

Fig. 1 shows a general schematic as a cross-sectional view of an exemplary RF sputtering chamber 100 according to one embodiment of the present invention. As shown in Fig. 5, a RF power source 102 is configured to control and supply RF power to the chamber 100. The RF power can be in the form of AC current having a frequency of about 500 kHz to 15 MHz, such as about 800 Hz to about 10 MHz. In particular embodiments, the RF power can be in the form of AC current having a frequency of about 1 MHz to about 5 MHz, such as about 2 MHz to about 3 MHz.

As shown, the RF power source applies a voltage to the cathode 104 to create a voltage potential between the cathode 104 and an anode formed by the chamber wall and/or the top support 106 and bottom support 107 via wires 108 and 109, respectively. Generally, the glass substrate 12 is positioned within the sputtering chamber 100 such that the TCO layer 14 is facing the cathode 104 in order to form the sputtered layer on the TCO layer 14.

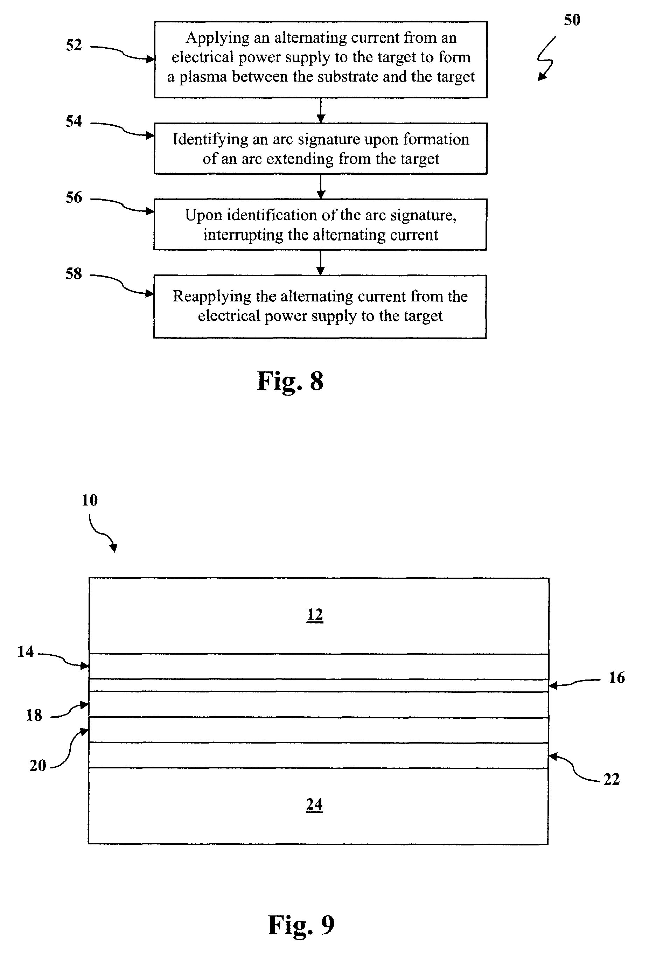

A plasma field 110 is created once the sputtering atmosphere is ignited, and is sustained in response to the voltage potential between the cathode 104 and the anode. The voltage potential causes the plasma ions within the plasma field 110 to accelerate toward the cathode 104, causing atoms from the cathode 104 to be ejected toward the TCO layer 14 on the glass substrate 12. As such, the cathode 104 can be referred to as a "target" and acts as the source material for the formation of the thin film layer (e.g., the cadmium sulfide layer 18 shown in Fig. 9) on the TCO layer 14. The cathode 104 can be a semiconducting target, such as cadmium sulfide, or mixtures thereof. Additionally, in some embodiments, a plurality of cathodes 104 can be utilized. A plurality of cathodes 104 can be particularly useful to form a layer including several types of materials (e.g., co-sputtering). The sputtering atmosphere forming the plasma field 110 generally contains an inert gas, such as argon. However, oxygen can be present in the sputtering atmosphere in certain embodiments.

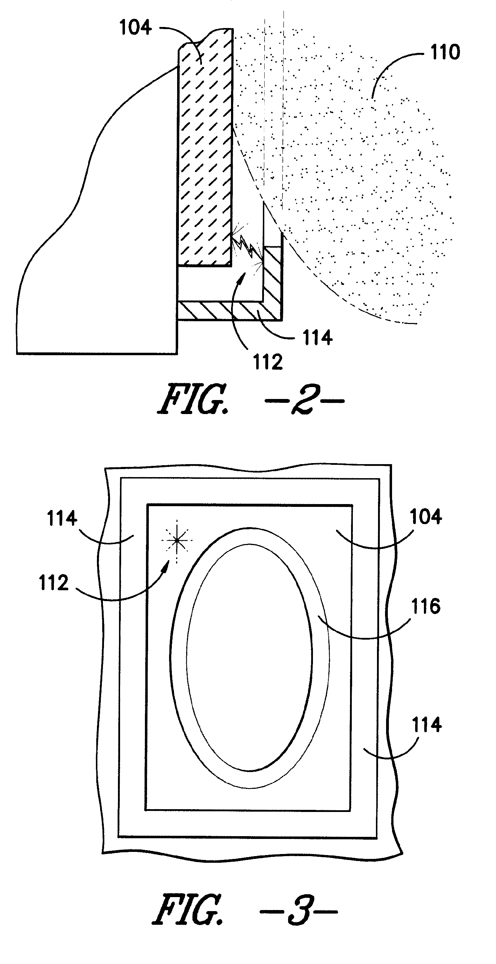

During the sputtering process within the RF sputtering chamber 100, arcs can form between the cathode 104 (i.e., the target) and other surfaces having an anode potential within the RF sputtering chamber 100. For example, Fig. 2 shows an arc 112 formed between the cathode 104 and the target shield 114 that surrounds the cathode 104.

In another instance, as shown in Fig. 3 and Fig. 4, an arc 112 can form between the cathode 104 and the plasma field 110 during sputtering. Fig. 3 also shows grooves 116 that can form in the cathode 104 during a prolonged sputtering process. These grooves 116 generally represent the target material that has been ejected off of the cathode 104 after sputtering for a prolonged period.

Detection of the formation of an arc 112 from the cathode 104 to any of the surfaces having an anode potential within the RF sputtering chamber 100 can be achieved by recognizing an arc signature formed upon the arc's formation. It has been found that the arc 112 simultaneously causes the plasma voltage to decrease and the reflective power to increase, creating a recognizable arc signature. This decrease in plasma voltage (i.e., from an initial sputtering plasma voltage to an arc plasma voltage) may be generally caused by the reaction of the impedance matching network of the power supply 102 adjusting to the arc while continuing to supply power to the cathode 104.

The arc signature can generally be identified when the arc plasma voltage is about 25% of the initial plasma voltage or less and the arc reflective power is about 25% of the initial sputtering reflective power or more. For example, in certain embodiments, an arc signature can generally be identified when the arc plasma voltage is about 33% of the initial plasma voltage or less (e.g., about 50% of the initial plasma voltage or less), and the arc reflective power is about 33% of the initial sputtering reflective power or more (e.g., about 50% of the initial sputtering reflective power or more). This simultaneous change in the plasma voltage and the reflective power can occur in less than about 1 second, such as from about 1 µs to about 100 ms. In certain embodiments, the simultaneous change in the plasma voltage and the reflective power can occur between about 10 µs to about 1 ms, such as from about 100 µs to about 500 µs. Thus, the arc signature can be identified quickly and the arc can be suppressed before the arc has sufficient time to intensify.

Sensors 120 are generally positioned within the RF sputtering chamber 100 adjacent to the area where the plasma field 110 forms between the cathode 104 and the glass substrate 12. The sensors 120 are configured to indicate the voltage across the plasma field 110 during sputtering (i.e., the plasma voltage). In particular embodiments, the sensors 120 are adjacent to the plasma field 110 such that an accurate measurement of the plasma voltage and reflected power can be performed. In one particular embodiment, an impedance matching network associated with the power source 102 can be used to detect changes in the plasma voltage and reflected power. A high speed control system configured for sampling at a rate of at least about 100 µs (e.g. from about 10 µs to about 50 µs) can be used to detect the arc signature.

During the sputtering process, both the plasma voltage and the reflective power can be continuously monitored, manually or automatically (e.g., using a computer). Upon detection of the arc signature, the arc detection controls 122 can temporarily interrupt the electrical power supplied to the cathode 104 from the RF power source 102. Referring to Fig. 5, for example, the arc detection controls 122 can open switch 124 upon detection of an arc signature, causing a loss of electrical power to the cathode 104 from the RF power source 102 and suppressing the arc 112. Upon suppression of the arc 112, the switch 124 can be closed to continue the supply of electrical power to the sputtering chamber. The electrical power (i.e., the alternating current) can be temporarily interrupted for a time sufficient to extinguish the arc while sustaining the plasma between the substrate and the semiconducting target, such as from about 10 µs to about 100 ms. In particular embodiments, electrical power can be temporarily interrupted for about 50 µs to about 1 ms, such as from about 100 µs to about 500 µs.

Although only a single RF power source 102 is shown, the voltage potential can be realized through the use of multiple power sources coupled together. Additionally, the exemplary sputtering chamber 100 is shown having a vertical orientation, although any other configuration can be utilized. When multiple power sources are utilized, the power from each source can be simultaneously interrupted to suppress an arc upon the detection of the arc signature.

Fig. 8 shows a flow diagram of an exemplary method 50 of arc suppression during sputtering of a thin film from a target onto a substrate. The method 50 includes applying an alternating current from an electrical power supply to the target to form a plasma between the substrate and the target at 52. For example the alternating current can have a frequency of about 500 kHz to 15 MHz. At 54, the arc signature (e.g,. defined by a decrease in plasma voltage from an initial sputtering plasma voltage to an arc plasma voltage and a simultaneous increase in reflective power from an initial sputtering reflective power to an arc reflective power) can be identified upon formation of an arc extending from the target. Upon identification of the arc signature, the alternating current can be interrupted from the electrical power supply to the target to suppress the arc extending from the target at 56. Finally, at 58, after interrupting the alternating current from the electrical power supply to the target, the alternating current can be reapplied from the electrical power supply to the semiconducting target.

The method of arc detection and suppression during the sputtering of a thin film on a substrate can be particularly useful in the formation of a cadmium telluride device, such as in the cadmium telluride thin film photovoltaic device disclosed in U.S. Publication No. 2009/0194165 of Murphy, et al. titled "Ultra-high Current Density Cadmium Telluride Photovoltaic Modules." In particular, the method of arc detection and suppression can be useful during the formation of a cadmium sulfide layer of a cadmium telluride thin film photovoltaic device, especially during the mass production of such devices.

Fig. 9 represents an exemplary cadmium telluride thin film photovoltaic device 10. The exemplary device 10 of Fig. 9 includes a top sheet of glass 12 employed as the substrate. In this embodiment, the glass 12 can be referred to as a "superstrate," since it is the substrate on which the subsequent layers are formed, but it faces upwards to the radiation source (e.g., the sun) when the cadmium telluride thin film photovoltaic device 10 is in used. The top sheet of glass 12 can be a high-transmission glass (e.g., high transmission borosilicate glass), low-iron float glass, or other highly transparent glass material. The glass is generally thick enough to provide support for the subsequent film layers (e.g., from about 0.5 mm to about 10 mm thick), and is substantially flat to provide a good surface for forming the subsequent film layers. In one embodiment, the glass 12 can be a low iron float glass containing less than about 0.15% by weight iron (Fe), and may have a transmissiveness of about 0.9 or greater in the spectrum of interest (e.g., wavelengths from about 300 nm to about 900 nm).

A transparent conductive oxide (TCO) layer 14 is shown on the glass 12 of the exemplary device 10 of Fig. 9. The TCO layer 14 allows light to pass through with minimal absorption while also allowing electric current produced by the device 10 to travel sideways to opaque metal conductors (not shown). For instance, the TCO layer 14 can have a sheet resistance less than about 30 ohm per square, such as from about 4 ohm per square to about 20 ohm per square (e.g., from about 8 ohm per square to about 15 ohm per square). The TCO layer 14 generally includes at least one conductive oxide, such as tin oxide, zinc oxide, or indium tin oxide, or mixtures thereof. Additionally, the TCO layer 14 can include other conductive, transparent materials. The TCO layer 14 can also include zinc stannate and/or cadmium stannate.

The TCO layer 14 can be formed by sputtering, chemical vapor deposition, spray pyrolysis, or any other suitable deposition method. In one particular embodiment, the TCO layer 14 can be formed by sputtering, either DC sputtering or RF sputtering, on the glass 12. For example, a cadmium stannate layer can be formed by sputtering a hot-pressed target containing stoichiometric amounts of SnO₂ and CdO onto the glass 12 in a ratio of about 1 to about 2. The cadmium stannate can alternatively be prepared by using cadmium acetate and tin (II) chloride precursors by spray pyrolysis.

In certain embodiments, the TCO layer 14 can have a thickness between about 0.1 µm and about 1 µm, for example from about 0.1 µm to about 0.5 µm, such as from about 0.25 µm to about 0.35 µm. Suitable flat glass substrates having a TCO layer 14 formed on the superstrate surface can be purchased commercially from various glass manufactures and suppliers. For example, a particularly suitable glass 12 including a TCO layer 14 includes a glass commercially available under the name TEC 15 TCO from Pilkington North America Inc. (Toledo, Ohio), which includes a TCO layer having a sheet resistance of 15 ohms per square.

A resistive transparent buffer layer 16 (RTB layer) is shown on the TCO layer 14 on the exemplary cadmium telluride thin film photovoltaic device 10. The RTB layer 16 is generally more resistive than the TCO layer 14 and can help protect the device 10 from chemical interactions between the TCO layer 14 and the subsequent layers during processing of the device 10. For example, in certain embodiments, the RTB layer 16 can have a sheet resistance that is greater than about 1000 ohms per square, such as from about 10 kOhms per square to about 1000 MOhms per square. The RTB layer 16 can also have a wide optical bandgap (e.g., greater than about 2.5 eV, such as from about 2.7 eV to about 3.0 eV).

Without wishing to be bound by a particular theory, it is believed that the presence of the RTB layer 16 between the TCO layer 14 and the cadmium sulfide layer 18 can allow for a relatively thin cadmium sulfide layer 18 to be included in the device 10 by reducing the possibility of interface defects (i.e., "pinholes" in the cadmium sulfide layer 18) creating shunts between the TCO layer 14 and the cadmium telluride layer 22. Thus, it is believed that the RTB layer 16 allows for improved adhesion and/or interaction between the TCO layer 14 and the cadmium telluride layer 22, thereby allowing a relatively thin cadmium sulfide layer 18 to be formed thereon without significant adverse effects that would otherwise result from such a relatively thin cadmium sulfide layer 18 formed directly on the TCO layer 14.

The RTB layer 16 can include, for instance, a combination of zinc oxide (ZnO) and tin oxide (SnO₂), which can be referred to as a zinc tin oxide layer ("ZTO"). In one particular embodiment, the RTB layer 16 can include more tin oxide than zinc oxide. For example, the RTB layer 16 can have a composition with a stoichiometric ratio of ZnO/SnO₂ between about 0.25 and about 3, such as in about an one to two (1:2) stoichiometric ratio of tin oxide to zinc oxide. The RTB layer 16 can be formed by sputtering, chemical vapor deposition, spraying pryolysis, or any other suitable deposition method. In one particular embodiment, the RTB layer 16 can be formed by sputtering, either DC sputtering or RF sputtering, on the TCO layer 14. For example, the RTB layer 16 can be deposited using a DC sputtering method by applying a DC current to a metallic source material (e.g., elemental zinc, elemental tin, or a mixture thereof) and sputtering the metallic source material onto the TCO layer 14 in the presence of an oxidizing atmosphere (e.g., O₂ gas). When the oxidizing atmosphere includes oxygen gas (i.e., O₂), the atmosphere can be greater than about 95% pure oxygen, such as greater than about 99%.

In certain embodiments, the RTB layer 16 can have a thickness between about 0.075 µm and about 1 µm, for example from about 0.1 µm to about 0.5 µm. In particular embodiments, the RTB layer 16 can have a thickness between about 0.08 µm and about 0.2 µm, for example from about 0.1 µm to about 0.15 µm.

A cadmium sulfide layer 18 is shown on resistive transparent buffer layer 16 of the exemplary device 10 of Fig. 9. The cadmium sulfide layer 18 is a n-type layer that generally includes cadmium sulfide (CdS) but may also include other materials, such as zinc sulfide, cadmium zinc sulfide, etc., and mixtures thereof as well as dopants and other impurities. In one particular embodiment, the cadmium sulfide layer may include oxygen up to about 25% by atomic percentage, for example from about 5% to about 20% by atomic percentage. The cadmium sulfide layer 18 can have a wide band gap (e.g., from about 2.25 eV to about 2.5 eV, such as about 2.4 eV) in order to allow most radiation energy (e.g., solar radiation) to pass. As such, the cadmium sulfide layer 18 is considered a transparent layer on the device 10.

The cadmium sulfide layer 18 can be formed by sputtering, chemical vapor deposition, chemical bath deposition, and other suitable deposition methods. In one particular embodiment, the cadmium sulfide layer 18 can be formed by sputtering, either direct current (DC) sputtering or radio frequency (RF) sputtering, on the resistive transparent layer 16. Sputtering deposition generally involves ejecting material from a target, which is the material source, and depositing the ejected material onto the substrate to form the film. DC sputtering generally involves applying a voltage to a metal target (i.e., the cathode) positioned near the substrate (i.e., the anode) within a sputtering chamber to form a direct-current discharge. The sputtering chamber can have a reactive atmosphere (e.g., an oxygen atmosphere, nitrogen atmosphere, fluorine atmosphere) that forms a plasma field between the metal target and the substrate. The pressure of the reactive atmosphere can be between about 1 mTorr and about 20 mTorr for magnetron sputtering. When metal atoms are released from the target upon application of the voltage, the metal atoms can react with the plasma and deposit onto the surface of the substrate. For example, when the atmosphere contains oxygen, the metal atoms released from the metal target can form a metallic oxide layer on the substrate. Conversely, RF sputtering generally involves exciting a capacitive discharge by applying an alternating-current (AC) or radio-frequency (RF) signal between the target (e.g., a ceramic source material) and the substrate. The sputtering chamber can have an inert atmosphere (e.g., an argon atmosphere) having a pressure between about 1 mTorr and about 20 mTorr.

Due to the presence of the resistive transparent layer 16, the cadmium sulfide layer 18 can have a thickness that is less than about 0.1 µm, such as between about 10 nm and about 100 nm, such as from about 50 nm to about 80 nm, with a minimal presence of pinholes between the resistive transparent layer 16 and the cadmium sulfide layer 18. Additionally, a cadmium sulfide layer 18 having a thickness less than about 0.1 µm reduces any adsorption of radiation energy by the cadmium sulfide layer 18, effectively increasing the amount of radiation energy reaching the underlying cadmium telluride layer 22.

A cadmium telluride layer 20 is shown on the cadmium sulfide layer 18 in the exemplary cadmium telluride thin film photovoltaic device 10 of Fig. 9. The cadmium telluride layer 20 is a p-type layer that generally includes cadmium telluride (CdTe) but may also include other materials. As the p-type layer of device 10, the cadmium telluride layer 20 is the photovoltaic layer that interacts with the cadmium sulfide layer 18 (i.e., the n-type layer) to produce current from the adsorption of radiation energy by absorbing the majority of the radiation energy passing into the device 10 due to its high absorption coefficient and creating electron-hole pairs. For example, the cadmium telluride layer 20 can generally be formed from cadmium telluride and can have a bandgap tailored to absorb radiation energy (e.g., from about 1.4 eV to about 1.5 eV, such as about 1.45 eV) to create the maximum number of electron-hole pairs with the highest electrical potential (voltage) upon absorption of the radiation energy. Electrons may travel from the p-type side (i.e., the cadmium telluride layer 20) across the junction to the n-type side (i.e., the cadmium sulfide layer 18) and, conversely, holes may pass from the n-type side to the p-type side. Thus, the p-n junction formed between the cadmium sulfide layer 18 and the cadmium telluride layer 20 forms a diode in which the charge imbalance leads to the creation of an electric field spanning the p-n junction. Conventional current is allowed to flow in only one direction and separates the light induced electron-hole pairs.

The cadmium telluride layer 20 can be formed by any known process, such as vapor transport deposition, chemical vapor deposition (CVD), spray pyrolysis, electrodeposition, sputtering, close-space sublimation (CSS), etc. In one particular embodiment, the cadmium sulfide layer 18 is deposited by a sputtering and the cadmium telluride layer 20 is deposited by close-space sublimation. In particular embodiments, the cadmium telluride layer 20 can have a thickness between about 0.1 µm and about 10 µm, such as from about 1 µm and about 5 µm. In one particular embodiment, the cadmium telluride layer 20 can have a thickness between about 2 µm and about 4 µm, such as about 3 µm.

A series of post-forming treatments can be applied to the exposed surface of the cadmium telluride layer 20. These treatments can tailor the functionality of the cadmium telluride layer 20 and prepare its surface for subsequent adhesion to the back contact layer(s) 22. For example, the cadmium telluride layer 20 can be annealed at elevated temperatures (e.g., from about 350° C to about 500° C, such as from about 375° C to about 424° C) for a sufficient time (e.g., from about 1 to about 10 minutes) to create a quality p-type layer of cadmium telluride. Without wishing to be bound by theory, it is believed that annealing the cadmium telluride layer 20 (and the device 10) converts the normally n-type cadmium telluride layer 20 to a p-type cadmium telluride layer 20 having a relatively low resistivity. Additionally, the cadmium telluride layer 20 can recrystallize and undergo grain growth during annealing.

Annealing the cadmium telluride layer 20 can be carried out in the presence of cadmium chloride in order to dope the cadmium telluride layer 20 with chloride ions. For example, the cadmium telluride layer 20 can be washed with an aqueous solution containing cadmium chloride then annealed at the elevated temperature.

In one particular embodiment, after annealing the cadmium telluride layer 20 in the presence of cadmium chloride, the surface can be washed to remove any cadmium oxide formed on the surface. This surface preparation can leave a Te-rich surface on the cadmium telluride layer 20 by removing oxides from the surface, such as CdO, CdTeO₃, CdTe₂O₅, etc. For instance, the surface can be washed with a suitable solvent (e.g., ethylenediamine also known as 1,2 diaminoethane or "DAE") to remove any cadmium oxide from the surface.

Additionally, copper can be added to the cadmium telluride layer 20. Along with a suitable etch, the addition of copper to the cadmium telluride layer 20 can form a surface of copper-telluride on the cadmium telluride layer 20 in order to obtain a low-resistance electrical contact between the cadmium telluride layer 20 (i.e., the p-type layer) and the back contact layer(s). Specifically, the addition of copper can create a surface layer of cuprous telluride (Cu₂Te) between the cadmium telluride layer 20 and the back contact layer 22. Thus, the Te-rich surface of the cadmium telluride layer 20 can enhance the collection of current created by the device through lower resistivity between the cadmium telluride layer 20 and the back contact layer 22.

Copper can be applied to the exposed surface of the cadmium telluride layer 20 by any process. For example, copper can be sprayed or washed on the surface of the cadmium telluride layer 20 in a solution with a suitable solvent (e.g., methanol, water, or the like, or combinations thereof) followed by annealing. In particular embodiments, the copper may be supplied in the solution in the form of copper chloride, copper iodide, or copper acetate. The annealing temperature is sufficient to allow diffusion of the copper ions into the cadmium telluride layer 20, such as from about 125° C to about 300° C (e.g. from about 150° C to about 200° C) for about 5 minutes to about 30 minutes, such as from about 10 to about 25 minutes.

A back contact layer 22 is shown on the cadmium telluride layer 20. The back contact layer 22 generally serves as the back electrical contact, in relation to the opposite, TCO layer 14 serving as the front electrical contact. The back contact layer 22 can be formed on, and in one embodiment is in direct contact with, the cadmium telluride layer 20. The back contact layer 22 is suitably made from one or more highly conductive materials, such as elemental nickel, chromium, copper, tin, aluminum, gold, silver, technetium or alloys or mixtures thereof. Additionally, the back contact layer 22 can be a single layer or can be a plurality of layers. In one particular embodiment, the back contact layer 22 can include graphite, such as a layer of carbon deposited on the p-layer followed by one or more layers of metal, such as the metals described above. The back contact layer 22, if made of or comprising one or more metals, is suitably applied by a technique such as sputtering or metal evaporation. If it is made from a graphite and polymer blend, or from a carbon paste, the blend or paste is applied to the semiconductor device by any suitable method for spreading the blend or paste, such as screen printing, spraying or by a "doctor" blade. After the application of the graphite blend or carbon paste, the device can be heated to convert the blend or paste into the conductive back contact layer. A carbon layer, if used, can be from about 0.1 µm to about 10 µm in thickness, for example from about 1 µm to about 5 µm. A metal layer of the back contact, if used for or as part of the back contact layer 22, can be from about 0.1 µm to about 1.5 µm in thickness.

The encapsulating glass 24 is also shown in the exemplary cadmium telluride thin film photovoltaic device 10 of Fig. 9.

Other components (not shown) can be included in the exemplary device 10, such as bus bars, external wiring, laser etches, etc. For example, when the device 10 forms a photovoltaic cell of a photovoltaic module, a plurality of photovoltaic cells can be connected in series in order to achieve a desired voltage, such as through an electrical wiring connection. Each end of the series connected cells can be attached to a suitable conductor such as a wire or bus bar, to direct the photovoltaically generated current to convenient locations for connection to a device or other system using the generated electric. A convenient means for achieving such series connections is to laser scribe the device to divide the device into a series of cells connected by interconnects. In one particular embodiment, for instance, a laser can be used to scribe the deposited layers of the semiconductor device to divide the device into a plurality of series connected cells.

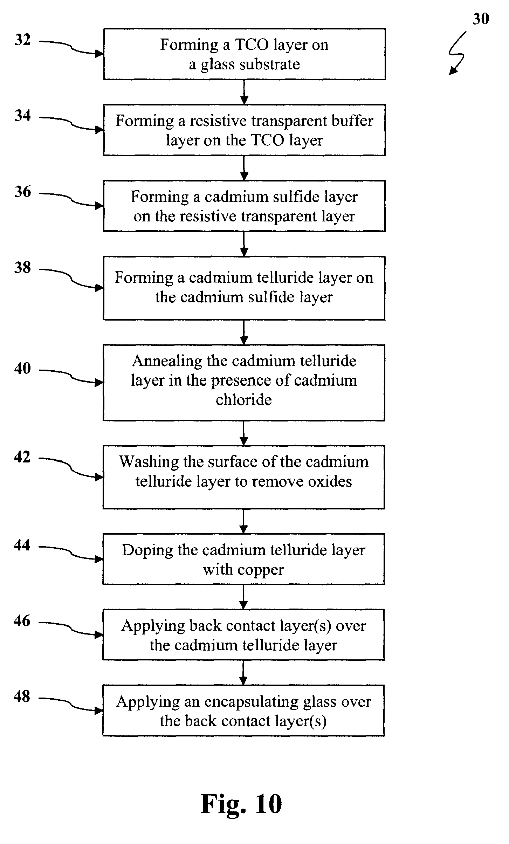

Fig. 10 shows a flow diagram of an exemplary method 30 of manufacturing a photovoltaic device according to one embodiment of the present invention. According to the exemplary method 30, a TCO layer is formed on a glass substrate at 32. At 34, a resistive transparent buffer layer is formed on the TCO layer. A cadmium sulfide layer is formed on the resistive transparent layer at 36, and a cadmium telluride layer is formed on the cadmium sulfide layer at 38. The cadmium telluride layer can be annealed in the presence of cadmium chloride at 40, and washed to remove any oxides formed on the surface at 42. The cadmium telluride layer can be doped with copper at 44. At 46, back contact layer(s) can be applied over the cadmium telluride layer, and an encapsulating glass can be applied over the back contact layer at 48.

One of ordinary skill in the art should recognize that other processing and/or treatments can be included in the method 30. For instance, the method may also include laser scribing to form electrically isolated photovoltaic cells in the device. These electrically isolated photovoltaic cells can then be connected in series to form a photovoltaic module. Also, electrical wires can be connected to positive and negative terminals of the photovoltaic module to provide lead wires to harness electrical current produced by the photovoltaic module.

### EXAMPLES

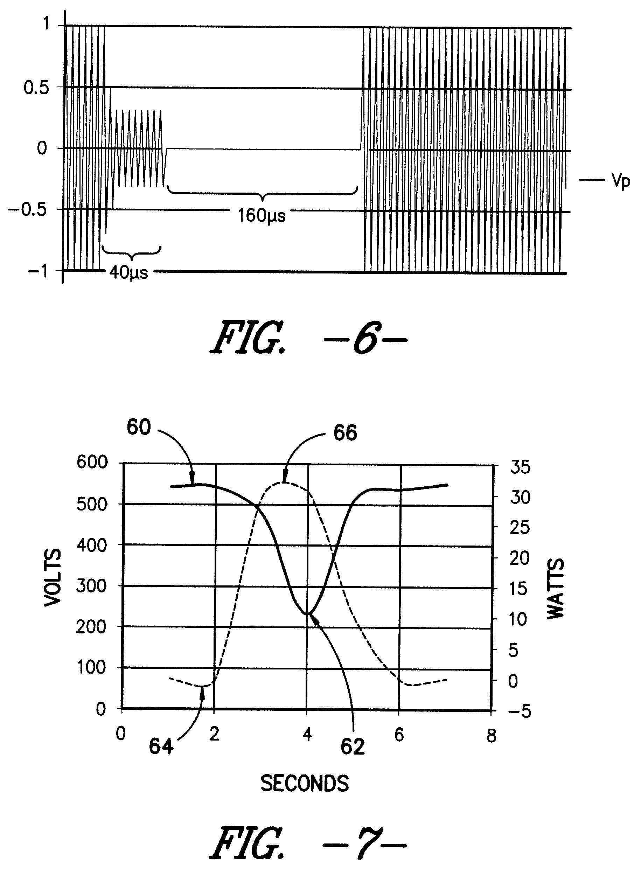

Fig. 6 shows the plasma voltage (V_{P}) response upon formation of an arc during RF sputtering of a cadmium sulfide layer on a substrate from a cadmium sulfide target at 2 MHz. The arc formed and reduced the plasma voltage from the initial plasma voltage to an arc plasma voltage that was less than about 50% of the initial plasma voltage (e.g., about 30% to about 40% of the initial plasma voltage) as shown by the decrease in amplitude of the wave shown. After 40 µs from the reduction of the plasma voltage, the electrical power was interrupted for 160 µs, which effectively suppressed the arc and returned the plasma voltage to the initial plasma voltage.

Fig. 7 shows an exemplary arc signature defined by an arc that was allowed to expand for two seconds before being suppressed. Specifically, Fig. 7 shows the initial sputtering plasma voltage 60 decreasing to the arc plasma voltage 62 while the initial sputtering reflective power 64 increases to an arc reflective power 66. The plasma voltage is generally the difference between the cathode potential (e.g., the target) and the anode potential (e.g., the sputtering chamber wall, dark space shields, etc., which is typically ground). The reflective power is measured at the power source and is generally the difference between the power delivered to the load (i.e., the plasma) from the power source and the power returned (i.e., "reflected") to the power source due to a mismatch in impedance between output impedance of the power source (e.g., about 50 omhs) and the impedance on the load (i.e., the plasma).

Although Fig. 7 is shown in seconds, this response will occur in microseconds (µm) to milliseconds (ms) in a sputtering chamber during deposition of a thin film layer.

This written description uses examples to disclose the invention, including the preferred mode, and also to enable any person skilled in the art to practice the invention, including making and using any devices or systems and performing any incorporated methods. The patentable scope of the invention is defined by the claims, and may include other examples that occur to those skilled in the art. Such other examples are intended to be within the scope of the claims if they include structural elements that do not differ from the literal language of the claims, or if they include equivalent structural elements with insubstantial differences from the literal languages of the claims.

Various aspects and embodiments of the present invention are defined by the following numbered clauses:
1. A method of arc suppression during sputtering of a thin film from a semiconducting target onto a substrate, the method comprising:
   applying an alternating current from an electrical power supply to the semiconducting target to form a plasma between the substrate and the semiconducting target, wherein the alternating current has a frequency of about 500 kHz to 15 MHz;
   identifying an arc signature upon formation of an arc extending from the target, wherein the arc signature is defined by a decrease in plasma voltage from an initial sputtering plasma voltage to an arc plasma voltage and a simultaneous increase in reflective power from an initial sputtering reflective power to an arc reflective power; and,
   upon identification of the arc signature, interrupting the alternating current from the electrical power supply to the semiconducting target to suppress the arc extending from the target.
2. The method as in clause 1, further comprising:
   after interrupting the alternating current from the electrical power supply to the semiconducting target, reapplying the alternating current from the electrical power supply to the semiconducting target.
3. The method as in any preceding clause, wherein the alternating current is interrupted for a specified time so as to extinguish the arc and maintain the plasma between the substrate and the semiconducting target.
4. The method as in any preceding clause, wherein the alternating current is interrupted for about 1 µs to about 100 ms.
5. The method as in any preceding clause, wherein the alternating current is interrupted for about 10 µs to about 1 ms.
6. The method as in any preceding clause, wherein the alternating current is interrupted for about 100 µs to about 500 µs.
7. The method as in any preceding clause, wherein the arc plasma voltage is about 25% of the initial plasma voltage or less, and wherein the arc reflective power is about 25% of the initial sputtering reflective power or more.
8. The method as in any preceding clause, wherein the arc plasma voltage is about 33% of the initial plasma voltage or less, and wherein the arc reflective power is about 33% of the initial sputtering reflective power or more.
9. The method as in any preceding clause, wherein the plasma voltage decreases from the initial sputtering plasma voltage to the arc plasma voltage and the reflective power increases from an initial sputtering reflective power to an arc reflective power in less than about 1 second.
10. The method as in any preceding clause, wherein the plasma voltage decreases from the initial sputtering plasma voltage to the arc plasma voltage and the reflective power increases from an initial sputtering reflective power to an arc reflective power in from about 10 µs to about 100 ms.
11. The method as in any preceding clause, wherein the plasma voltage decreases from the initial sputtering plasma voltage to the arc plasma voltage and the reflective power increases from an initial sputtering reflective power to an arc reflective power in from about 50 µs to about 1 ms.
12. The method as in any preceding clause, wherein the plasma voltage decreases from the initial sputtering plasma voltage to the arc plasma voltage and the reflective power increases from an initial sputtering reflective power to an arc reflective power in from about 100 µs to about 500 µs.
13. A method for sputtering a cadmium sulfide layer on a glass superstrate while detecting and suppressing arc formation, the method comprising:
   applying an alternating current from an electrical power supply to a cadmium sulfide target to form a plasma between the glass superstrate and the target, wherein the alternating current has a frequency of about 500 kHz to 15 MHz;
   identifying an arc signature upon formation of an arc extending from the target, wherein the arc signature is defined by a decrease in plasma voltage from an initial sputtering plasma voltage to an arc plasma voltage and a simultaneous increase in reflective power from an initial sputtering reflective power to an arc reflective power; and,
   upon identification of the arc signature, interrupting the alternating current from the electrical power supply to the target to suppress the arc extending from the target.
14. A method as in any preceding clause, further comprising:
   after interrupting the alternating current from the electrical power supply to the target, reapplying the alternating current from the electrical power supply to the target.
15. The method as in any preceding clause, wherein the alternating current is interrupted for a specified time so as to extinguish the arc and maintain the plasma between the substrate and the semiconducting target.
16. The method as in any preceding clause, wherein the alternating current is interrupted for about 1 µs to about 100 ms.
17. The method as in any preceding clause, wherein the arc plasma voltage is about 25% of the initial plasma voltage or less, and wherein the arc reflective power is about 25% of the initial sputtering reflective power or more.
18. The method as in any preceding clause, wherein the arc plasma voltage is about 50% of the initial plasma voltage or less, and wherein the arc reflective power is about 50% of the initial sputtering reflective power or more.
19. The method as in any preceding clause, wherein the plasma voltage decreases from the initial sputtering plasma voltage to the arc plasma voltage and the reflective power increases from an initial sputtering reflective power to an arc reflective power in from about 10 µs to about 100 ms.
20. A sputtering system for arc detection and suppression during sputtering of a thin film from a semiconducting target onto a substrate, the system comprising
   a sputtering chamber configured to receive a substrate and a semiconductor target;
   an electrical power supply wired to the sputtering chamber to supply alternating current to the semiconducting target to form a plasma between the substrate and the semiconducting target, wherein the alternating current has a frequency of about 500 kHz to 15 MHz;
   a switch between the electrical power supply and the sputtering chamber configured to supply the alternating current to the sputtering chamber when closed and interrupt the alternating current to the sputtering chamber when open;
   a pair of sensors positioned within the sputtering chamber to measure the plasma voltage and the reflective power during sputtering; and,
   an arc detection control configured to open the switch to interrupt the alternating current to the sputtering chamber upon detection of an arc signature simultaneously defined by decreasing plasma voltage and increasing reflective power measured by the pair of sensors.

## Claims

1. A method of arc suppression during sputtering of a thin film (20) from a semiconducting (104) target onto a substrate (12), the method comprising:
applying an alternating current from an electrical power supply to the semiconducting target to form a plasma between the substrate and the semiconducting target, wherein the alternating current has a frequency of about 500 kHz to 15 MHz;
identifying an arc signature upon formation of an arc extending from the target, wherein the arc signature is defined by a decrease in plasma voltage from an initial sputtering plasma voltage to an arc plasma voltage and a simultaneous increase in reflective power from an initial sputtering reflective power to an arc reflective power; and
upon identification of the arc signature, interrupting the alternating current from the electrical power supply to the semiconducting target to suppress the arc extending from the target.

2. A method for sputtering a cadmium sulfide layer on a glass superstrate (12) while detecting and suppressing arc formation, the method comprising:
applying an alternating current from an electrical power supply to a cadmium sulfide target to form a plasma between the glass superstrate and the target, wherein the alternating current has a frequency of about 500 kHz to 15 MHz;
identifying an arc signature upon formation of an arc extending from the target, wherein the arc signature is defined by a decrease in plasma voltage from an initial sputtering plasma voltage to an arc plasma voltage and a simultaneous increase in reflective power from an initial sputtering reflective power to an arc reflective power; and
upon identification of the arc signature, interrupting the alternating current from the electrical power supply to the target to suppress the arc extending from the target.

3. The method as in claim 1 or 2, further comprising:
after interrupting the alternating current from the electrical power supply to the semiconducting target (104), reapplying the alternating current from the electrical power supply to the semiconducting target.

4. The method as in claim 3, wherein the alternating current is interrupted for a specified time so as to extinguish the arc and maintain the plasma between the substrate (12) and the semiconducting target (104).

5. The method as in any preceding claim, wherein the alternating current is interrupted for about 1 µs to about 100 ms, preferably for about 10 µs to about 1 ms, and more preferably for about 100 µs to about 500 µs.

6. The method as in any preceding claim, wherein the arc plasma voltage is about 25% of the initial plasma voltage or less and the arc reflective power is about 25% of the initial sputtering reflective power or more.

7. The method as in any preceding claim, wherein the arc plasma voltage is about 33% of the initial plasma voltage or less and the arc reflective power is about 33% of the initial sputtering reflective power or more.

8. The method as in any preceding claim, wherein the arc plasma voltage is about 50% of the initial plasma voltage or less, and wherein the arc reflective power is about 50% of the initial sputtering reflective power or more.

9. The method as in any preceding claim, wherein the plasma voltage decreases from the initial sputtering plasma voltage to the arc plasma voltage and the reflective power increases from an initial sputtering reflective power to an arc reflective power in less than about 1 second.

10. The method as in any preceding claim, wherein the plasma voltage decreases from the initial sputtering plasma voltage to the arc plasma voltage and the reflective power increases from an initial sputtering reflective power to an arc reflective power in from about 10 µs to about 100 ms, preferably from about 50 µs to about 1 ms, and more preferably from about 100 µs to about 500 µs.

11. A sputtering system for arc detection and suppression during sputtering of a thin film from a semiconducting target (104) onto a substrate (12), the system comprising
a sputtering chamber (100) configured to receive a substrate (12) and a semiconductor target (104);
an electrical power supply (102) wired to the sputtering chamber (100) to supply alternating current to the semiconducting target (104) to form a plasma field (110) between the substrate (12) and the semiconducting target (104), wherein the alternating current has a frequency of about 500 kHz to 15 MHz;
a switch (124) between the electrical power supply (102) and the sputtering chamber (100) configured to supply the alternating current to the sputtering chamber (100) when closed and interrupt the alternating current to the sputtering chamber (100) when open;
a pair of sensors (120) positioned within the sputtering chamber (110) to measure the plasma voltage and the reflective power during sputtering; and
an arc detection control (122) configured to open the switch (124) to interrupt the alternating current to the sputtering chamber (100) upon detection of an arc signature simultaneously defined by decreasing plasma voltage and increasing reflective power measured by the pair of sensors (120).
